# EUROPÄISCHE PATENTSCHRIFT

(11) **EP 1 188 188 B1**
(45) Veröffentlichungstag und Bekanntmachung des Hinweises auf die Patenterteilung: **31.08.2005**
(21) Anmeldenummer: 00951234.4
(22) Anmeldetag: 21.06.2000
(51) Int. Cl.: H01L 29/786, H01L 21/336

(54) **VERFAHREN ZUR HERSTELLUNG EINES MEHRKANAL-MOSFETS**
METHOD FOR PRODUCING A MULTI-CHANNEL MOSFET
PROCEDE DE PRODUCTION D'UN TRANSISTOR MOSFET MULTICANAL

(30) Priorität: 22.06.1999 DE 19928564
(43) Veröffentlichungstag der Anmeldung: 20.03.2002
(73) Patentinhaber: Infineon Technologies AG, 81669 München (DE)
(72) Erfinder: RÖSNER, Wolfgang, D-81739 München (DE); SCHULZ, Thomas, D-81737 München (DE); RISCH, Lothar, D-85579 Neubiberg (DE); FRANOSCH, Martin, D-81739 München (DE)
(74) Vertreter: Lange, Thomas
(86) Internationale Anmeldenummer: PCT/DE2000/002022
(87) Internationale Veröffentlichungsnummer: WO 2000/079602

(56) Entgegenhaltungen:
- EP-A- 0 612 103
- EP-A- 0 704 909
- DE-A- 19 803 479
- US-A- 5 120 666
- US-A- 5 646 058

## Beschreibung

Die Erfindung betrifft Verfahren zur Herstellung einer MOS-Transistoranordnung nach den Patentansprüchen 1 und 10.

MOSFETs (metal-oxide-semiconductor field-effect transistors) werden seit langem bei ständiger Verkleinerung ihrer Strukturen in den unterschiedlichsten integrierten Halbleiterschaltkreisen (z.B. DRAMs, ROMs, EPROMs, EEPROMs, PLAs, usw.) eingesetzt.

Die voranschreitende Verkleinerung von Bulk-MOS-Transistoren wird durch die bekannten Kurzkanaleffekte in absehbarer Zeit an ihre Grenze stoßen. Das Prinzip des MOS-Transistors kann aber darüber hinaus noch weiter bis hinab zu Kanallängen von 10 nm oder sogar darunter genutzt werden. Voraussetzung ist ein weitestgehender Durchgriff des Gatepotentials durch das gesamte Kanalgebiet, was, wie in der Veröffentlichung von F. G. Pikus et al. in Appl. Phys. Lett. 71, 3661 (1997) gezeigt wird, am besten bei sogenannten Doppel-Gate-MOSFETs mit sehr dünnem Si-Kanalgebiet erreicht wird.

Doppel-Gate-MOSFETs unterscheiden sich von herkömmlichen (Einzel-Gate-)MOSFETs dadurch, daß sie zusätzlich zu der üblichen oberhalb des Kanals angeordneten Gateelektrode (top gate) eine weitere unter dem Transistorkanal liegende Gateelektrode (bottom gate) aufweisen.

Die Realisierung derartiger Doppel-Gate-MOSFETs konnte bisher nur im Labormaßstab erfolgen. J. P. Colinge et al. haben in IEDM 90-595 ein Verfahren vorgeschlagen, bei welchem auf einem SOI-(silicon-on-insulator-)Substrat das Oxid im Bereich unter dem Transistorkanal naßchemisch entfernt und dieser Raum später mit dem Polysilizium des Rückseiten-Gates aufgefüllt wird. Dieses Verfahren ist technologisch einfach, weist jedoch den Nachteil auf, daß mit ihm keine selbstjustierten Doppel-Gate-MOSFETs hergestellt werden können. Ein weiterer Nachteil des Verfahrens besteht darin, daß die Ätzung unter dem Transistorkanal nicht auf einen kleinen Bereich beschränkt werden kann.

In dem US-Patent 5,646,058 wird ein Prozeß zur Herstellung von Doppel-Gate-MOSFETs vorgeschlagen, bei dem das dünne Silizium-Kanalgebiet innerhalb eines zuvor gebildeten dünnen Tunnels epitaktisch aufgewachsen wird. Dieser Prozeß ist prozeßtechnisch anspruchsvoll, ermöglicht allerdings die Herstellung selbstjustierter Doppel-Gate-MOSFETs.

In der deutschen Offenlegungsschrift DE 198 03 479 ist ein Dünnfilmtransistor beschrieben, welcher mehrere übereinanderliegend angeordnete Kanalschichten mit dazwischenliegenden Gatelektroden aufweist. Dieser Schichtaufbau wird durch eine sukzessive Abfolge von Abscheide- und Ätzschritten erzeugt.

Ein besonders geeignetes Verfahren zur Herstellung selbstjustierter Doppel-Gate-MOSFETs ist in der nicht vorveröffentlichten deutschen Patentanmeldung 199 245 71.1 angegeben.

Für viele praktische Anwendungen ist es wünschenswert, MOSFETs mit hoher Stromtreiberfähigkeit einsetzen zu können.

Demzufolge liegt der vorliegenden Erfindung die Aufgabe zugrunde, Verfahren zur Herstellung einer MOS-Transistoranordnung mit hoher Stromtreiberfähigkeit anzugeben.

Diese Aufgabe wird durch Verfahren nach den Patentansprüchen 1 und 10 gelöst.

Ein erstes bevorzugtes Verfahren zur Herstellung eines Mehrkanal-MOSFET kennzeichnet sich durch die Merkmale des Anspruchs 1. Mit diesem Verfahren können selbstjustierte Mehrkanal-MOSFETs mit Kanalschichtzonen aus kristallinem Silizium, Polysilizium oder auch amorphem Silizium realisiert werden. Je nachdem, ob eine bodenseitige platzhaltende Schicht auf das Substrat aufgebracht wird oder nicht, kann ein Doppel-Gate-MOSFET mit darüberliegend angeordnetem weiteren Transistorkanal oder ein top gate MOSFET mit darüberliegend angeordnetem Doppel-Gate-MOSFET realisiert werden.

Ein zweites bevorzugtes Verfahren zur Herstellung eines Mehrkanal-MOSFET mit kristallinen Kanalschichtzonen kennzeichnet sich durch die Merkmale des Anspruchs 10 und bildet im wesentlichen das in der eingangs genannten US 5,646,058 beschriebene Verfahren fort.

Beiden erfindungsgemäßen Verfahren zur Herstellung eines Mehrkanal-MOSFET ist gemeinsam, daß sie nur einen verhältnismäßig geringen zusätzlichen Prozeßaufwand gegenüber den jeweilig zugrundeliegenden Doppel-Gate-MOSFET-Herstellungsverfahren erforderlich machen.

Die MOS-Transistoranordnung, welche durch die erfindungsgemäßen Verfahren hergestellt wird, umfaßt einen Doppel-Gate-MOSFET, der an seinem "top gate" und/oder seinem "bottom gate" mit zumindest einem weiteren Transistorkanal (Halbleiter-Kanalschichtzone) ausgerüstet ist. Durch den oder die weiteren Transistorkanäle kann bei gleichem Flächenbedarf der Source-Drain-Strom vervielfacht werden. Darüber hinaus sind die elektrischen Eigenschaften des erfindungsgemäßen Mehrkanal-MOSFETs deutlich verbessert, da die Gateelektroden und Kanalschichtzonen bedingt durch ihre Erzeugung mittels eines selbstjustierenden Prozesses in zueinander ausgerichteter Lagebeziehung angeordnet sind.

Eine MOS-Transistoranordnung, welche durch die erfindungsgemäßen Verfahren hergestellt wird, wird im folgenden auch als Mehrkanal-MOSFET bezeichnet.

Nach einer bevorzugten Ausführungsvariante der MOS-Transistoranordnung ist die weitere Halbleiter-Kanalschichtzone an ihrer der ersten oder zweiten Gateelektrode gegenüberliegenden Oberfläche mit einer weiteren Gateelektrode versehen. Die sich ergebende Struktur entspricht zwei übereinander angeordneten Doppel-Gate-MOSFETs mit gemeinsamer (erster oder zweiter) Mittengateelektrode.

Die Halbleiter-Kanalschichtzonen können aus Silizium, insbesondere kristallinem Silizium bestehen. Die erfindungsgemäßen Verfahren sind jedoch insbesondere auch auf MOS-Transistorstrukturen mit aus polykristallinem oder amorphem Silizium bestehenden Halbleiter-Kanalschichtzonen anwendbar, da durch die erfindungsgemäße Maßnahme die ansonsten schlechte Stromergiebigkeit gerade solcher MOSFET-Strukturen entscheidend verbessert wird.

Vorzugsweise wird als Substrat ein Siliziumsubstrat oder ein SOI-Substrat eingesetzt.

Weitere vorteilhafte Ausgestaltungen der Erfindung sind in den Unteransprüchen angegeben.

Im folgenden werden zwei Beispiele eines Mehrkanal-MOSFETs sowie zwei Ausführungsvarianten erfindungsgemäßer Herstellungsverfahren anhand der Zeichnung erläutert. Es zeigen:
Fig. 1 eine schematische Schnittansicht in Kanalrichtung (Linie B-B der Fig. 2) eines ersten Beispiels eines Mehrkanal-MOSFET;
Fig. 2 eine schematische Darstellung der geometrischen Verhältnisse der bei einer ersten Ausführungsvariante eines erfindungsgemäßen Herstellungsverfahrens zu prozessierenden Bereiche in Draufsicht;
Fig. 3 eine schematische Schnittansicht entlang der Linie A-A in Fig. 2 nach dem Aufbringen der für die Transistorkanäle vorgesehenen Siliziumschichten bei der ersten Ausführungsvariante;
Fig. 4 und 5 schematische Schnittansichten entlang der Linie A-A zu späteren Zeitpunkten im Prozeßablauf der ersten Ausführungsvariante;
Fig. 6 eine schematische Schnittansicht in Kanalrichtung nach dem Aufbringen der Schichtfolge bei der zweiten Ausführungsvariante eines erfindungsgemäßen Herstellungsverfahrens;
Fig. 7 bis 10 schematische Schnittansichten gemäß Fig. 6 zu späteren Zeitpunkten im Prozeßablauf der zweiten Ausführungsvariante;
Fig. 11 eine schematische Schnittansicht in Kanalrichtung des gemäß der zweiten Ausführungsvariante hergestellten Beispiels eines Mehrkanal-MOSFETs.

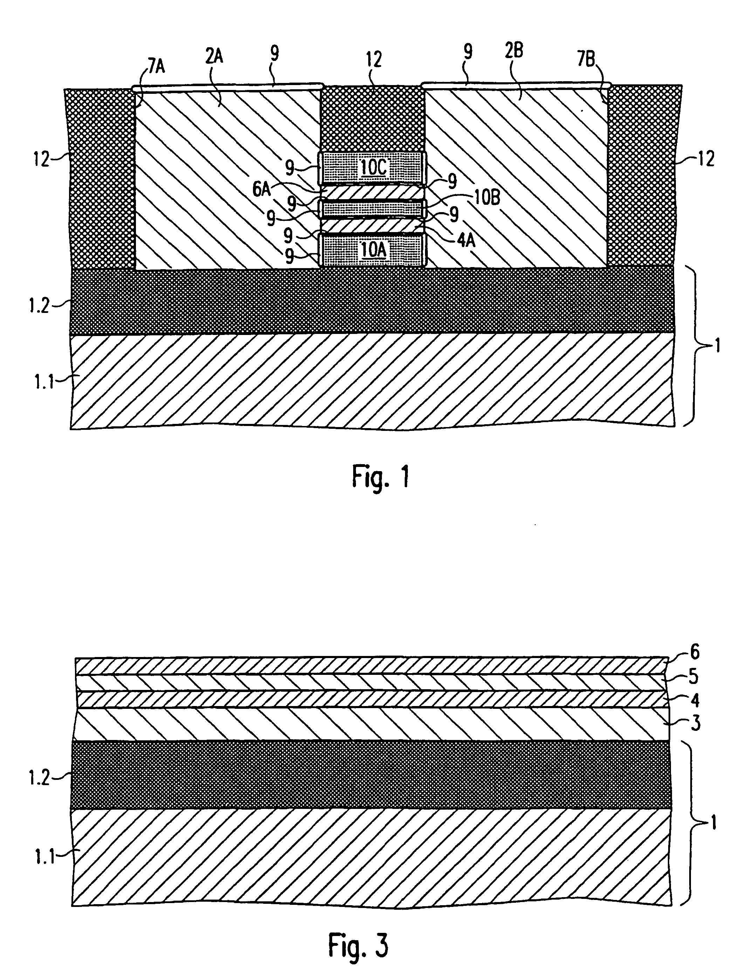

Fig. 1 zeigt einen auf einem SOI-Substrat 1 bestehend aus einem Basis-Substratbereich 1.1 und einer darüberliegenden Oxidschicht 1.2 aufgebauten Mehrkanal-MOSFET. Der Mehrkanal-MOSFET weist zwei übereinander angeordnete, parallele Halbleiter-Kanalschichtzonen 4A, 6A auf, die sich zwischen gemeinsamen Source- 2A und Drain-Bereichen 2B erstrecken. Zwischen dem SOI-Substrat 1 (d.h. der Oxidschicht 1.2) und der untersten Kanal-Halbleiterschichtzone 4A, zwischen den Kanal-Halbleiterschichtzonen 4A und 6A und oberhalb der oberen Kanal-Halbleiterschichtzone 6A befinden sich Gateelektroden 10A, 10B und 10C. Die Gateelektroden 10A, 10B, 10C sind mittels Oxidschichten 9 sowohl gegenüber den Source- 2A und Drain-Bereichen 2B als auch gegenüber den Halbleiter-Kanalschichtzonen 4A, 4B elektrisch isoliert.

Über der obersten Gateelektrode 10C sowie im Bereich außerhalb der Source- 2A und Drain-Bereiche 2B ist ein Isolationsmaterial 12 abgelagert. Die Source- 2A und Drain-Bereiche 2B sind ebenfalls durch eine Oxidschicht 9 abgedeckt.

Der in Fig. 1 dargestellte Mehrkanal-MOSFET entspricht konstruktiv zwei übereinander angeordneten Doppel-Gate-MOSFETs mit gemeinsamer Gateelektrode 10B. Die unterste Gateelektrode 10A kann jedoch auch entfallen, wodurch eine Anordnung bestehend aus einem unteren top gate MOSFET und einem darüber angeordneten Doppel-Gate-MOSFET mit gemeinsamer Gateelektrode 10B realisiert wird. Ferner kann die Oxidschicht 1.2 entfallen, d.h. ein Substrat 1 aus einem Vollmaterial, insbesondere Si-Substrat (Si-Wafer) eingesetzt werden. Schließlich können auch mehr als zwei übereinander angeordnete Halbleiter-Kanalschichtzonen 4A, 6A vorhanden sein, wodurch die Stromtreiberfähigkeit der Anordnung weiter erhöht wird.

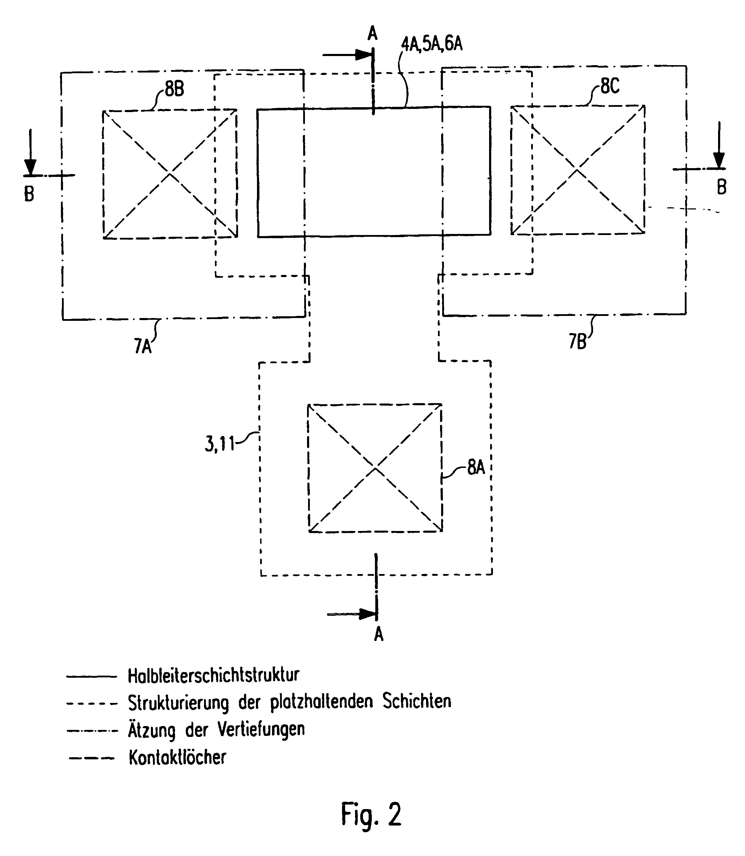

Eine erste Ausführungsvariante zur Herstellung des in Fig. 1 dargestellten Mehrkanal-MOSFETs wird im folgenden anhand der Fig. 2 bis 5 erläutert.

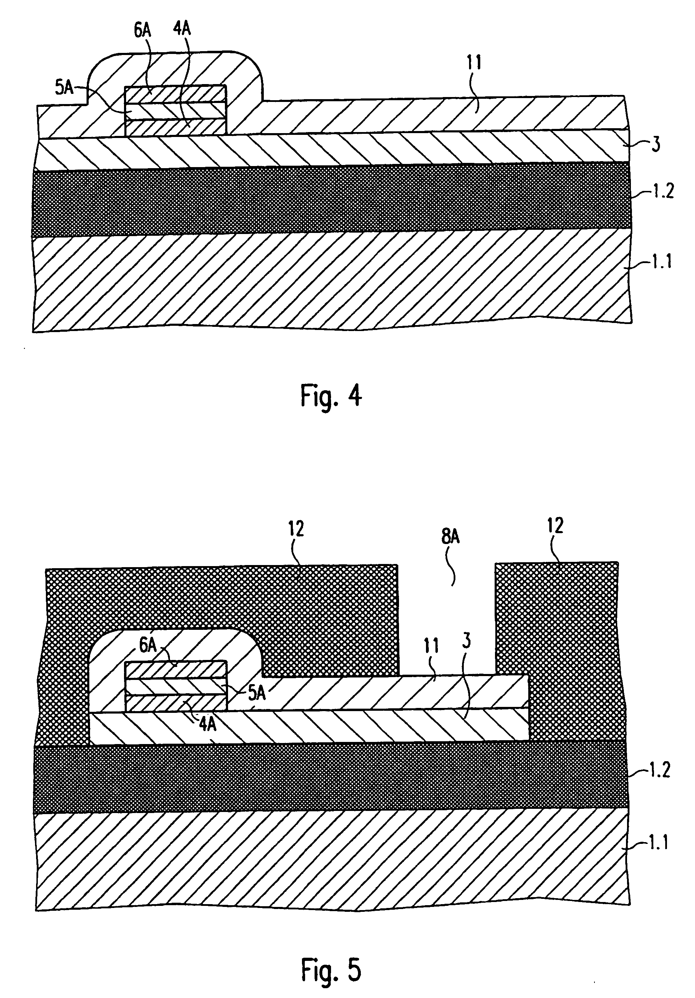

Gemäß Fig. 3 wird auf dem SOI-Substrat 1 zunächst eine bodenseitige platzhaltende Schicht 3, nachfolgend eine erste Halbleiter-Kanalschicht 4, eine weitere platzhaltende Schicht 5 und eine zweite Halbleiter-Kanalschicht 6 abgeschieden.

Die Halbleiter-Kanalschichten 4, 6 können beispielsweise aus kristallinem Silizium bestehen. Es ist jedoch auch möglich, die Halbleiter-Kanalschichten 4, 6 durch Abscheidung polykristallinen Siliziums oder sogar amorphen Siliziums zu bilden. Zwar ist die Ladungsträgerbeweglichkeit in polykristallinen und besonders in amorphen Schichten relativ stark eingeschränkt. Das geringe Volumen der Kanalzonen, der vollständige Durchgriff des Gatepotentials und vor allem natürlich die Parallellegung mehrerer Transistorkanäle lassen jedoch auch in diesem Fall eine brauchbare Leistung der - auf diese Weise sehr kostengünstig herstellbaren - Transistoranordnung erwarten.

Ferner besteht die Möglichkeit, die Halbleiter-Kanalschichten 4, 6 zunächst als polykristalline oder amorphe Schichten abzuscheiden und durch anschließendes Rekristallisieren, beispielsweise Laser-Rekristallisieren in kristalline Schichten umzuwandeln.

Die platzhaltenden Schichten 3, 5 können aus Siliziumnitrid (SiN) bestehen.

Bei polykristallinen oder ggf. sogar amorphen Halbleiter-Kanalschichten 4, 6 können die Kanalschichten und das Platzhaltermaterial in der gleichen Anlage einfach alternierend abgeschieden werden. Beispielsweise kann das Polysilizium der platzhaltenden Schichten 3, 5 hoch mit P dotiert werden, wodurch sie später mittels heißer H₃PO₄ selektiv zum niedriger dotierten Polysilizium der Kanalschichten geätzt werden können. Auch 1%ige HF ätzt dotiertes Polysilizium etwa 12 mal schneller als undotiertes Polysilizium. Eine weitere Möglichkeit besteht in der abwechselnden Abscheidung von Polysilizium (Halbleiter-Kanalschichten) und Poly-SiGe (platzhaltende Schichten). Poly-SiGe kann beispielsweise mit HF:H₂O:CH₃OOH im Mischungsverhältnis 1:2:3 naßchemisch aus dem umgebenden Polysilizium herausgeätzt werden.

Für einkristalline Halbleiter-Kanalschichten 4, 6 können mittels Epitaxie in ähnlicher Weise Schichtfolgen mit unterschiedlichem Dotierungsgrad oder bestehend aus verschiedenen, selektiv ätzbaren Materialien (neben Si für die Halbleiter-Kanalschichten beispielsweise CaF₂ oder SiGe für die platzhaltenden Schichten) eingesetzt werden.

Das SOI-Substrat 1 kann durch eines der in der Technik bekannten Verfahren vorgefertigt werden.

Es ist auch möglich, zunächst die Schichtenanordnung 1.1, 1.2, 3, 4 durch Waferbonding herzustellen, und nachfolgend die restlichen Schichten 5, 6 in der bereits beschriebenen Weise aufzubringen. Dabei werden getrennt voneinander auf einen ersten Siliziumwafer eine Oxidschicht (Bezugszeichen 1.2) und auf einen zweiten Siliziumwafer eine Nitridschicht (Bezugszeichen 3) aufgewachsen und die beiden Siliziumwafer an der Oxid- bzw. der Nitridschicht durch das an sich im Stand der Technik bekannte Waferbonding-Verfahren aneinander fixiert. Anschließend muß bei diesem Prozeß der zweite Siliziumwafer durch Polieren und/oder Ätzen auf die gewünschte Dicke gebracht werden. Es ergibt sich eine kristalline Halbleiter-Kanalschicht 4.

Nach Fertigstellung der in Fig. 3 dargestellten Schichtanordnung wird die erste Halbleiter-Kanalschicht 4, die platzhaltende Schicht 5 und die zweite Halbleiter-Kanalschicht 6 durch ein geeignetes Verfahren teilweise entfernt, wobei eine Schichtstruktur 4A, 5A, 6A davon stehenbleibt, die im vorliegenden Fall eine rechteckförmige Form aufweist, welche in Fig. 2 durch die durchgezogene Linie 4A/5A/6A dargestellt ist.

Diese rechteckförmige Schichtstruktur 4A, 5A, 6A wird anschließend von einer weiteren platzhaltenden Schicht 11, z.B. aus SiN oder einem der anderen genannten Materialien überwachsen, so daß die Schichtstruktur 4A, 5A, 6A wie in Fig. 4 dargestellt von dem Material der platzhaltenden Schicht 11 vollständig umschlossen ist.

Anschließend werden die bodenseitige und die oberste platzhaltende Schicht 3 und 11 durch ein geeignetes Verfahren derart strukturiert, daß ein Bereich davon stehenbleibt, wie er in Fig. 2 durch die gestrichelte Linie gezeigt ist. Dieser Bereich weist im wesentlichen zwei rechteckförmige Abschnitte auf, die durch einen Steg miteinander verbunden sind. Der in der Darstellung der Fig. 2 obere rechteckförmige Bereich enthält die eingebettete Halbleiterschichtstruktur 4A, 5A, 6A. Außerhalb des Bereichs der gestrichelten Linie in Fig. 2 liegt die Oxidschicht 1.2 des SOI-Substrats 1 an der Oberfläche.

Auf diese Struktur wird nun eine weitere Oxidschicht 12 abgeschieden und anschließend deren Oberfläche planarisiert, wie in Fig. 5 zu erkennen ist. Die Planarisierung kann beispielsweise durch chemisch-mechanisches Polieren (CMP) erfolgen.

Anschließend werden in den in Fig. 2 strichpunktierten Bereichen vertikale Vertiefungen 7A, 7B in die Struktur geätzt, wobei jeweils in den Vertiefungen 7A, 7B die bodenseitige und die oberste platzhaltende Schicht 3, 11 und jeweils beidseitig ein Randabschnitt der Halbleiterschichtstruktur 4A, 5A, 6A vollständig durch- bzw. weggeätzt werden, siehe Fig. 1. Die strichpunktierten, zu ätzenden Bereiche liegen sich in der Draufsicht der Fig. 2 auf den kurzen Seiten des rechteckförmigen Bereichs 4A/5A/6A gegenüber, wobei beidseitig ein geringfügiger Überlapp mit dem rechteckförmigen Bereich 4A/5A/6A besteht. Bei der Ätzung wird also der rechteckförmige Bereich 4A/5A/6A in beiden Vertiefungen 7A, 7B angeätzt und dabei Seitenwände desselben freigelegt. Die freigelegten Seitenwände definieren die Kanallänge der herzustellenden Transistoranordnung entlang der Linie B-B. Wie ferner in Fig. 1 zu erkennen ist, werden in die Tiefe die platzhaltenden Schichten 3, 11 und die Schichten 4, 5, 6 vollständig durchgeätzt, so daß die Oxidschicht 1.2 an der Oberfläche leicht angeätzt wird. Für den Ätzvorgang kann die Oxidschicht 1.2 als Ätzstoppschicht verwendet werden.

In den Vertiefungen 7A, 7B werden anschließend durch Auffüllen mit elektrisch leitfähigem Material die Source- und Drain-Bereiche 2A, 2B hergestellt. Als Füllmaterial kann beispielsweise hochdotiertes Polysilizium, ein Metall oder ein Metallsilizid verwendet werden. Die Abscheidung des Materials muß langsam erfolgen, so daß die Vertiefungen 7A, 7B vollständig gefüllt werden, bevor die Öffnung zuwächst. Die Source- und Drain-Bereiche 2A, 2B stehen nach diesem Verfahrensschritt auf beiden Seiten mit den Seitenwänden der Halbleiterstruktur 4A, 5A, 6A in Kontakt. Anschließend erfolgt auch hier eine Planarisierung der Oberfläche, die beispielsweise durch Rückätzen oder CMP durchgeführt werden kann.

Dann wird ein erstes Kontaktloch 8A im Bereich des unteren rechteckförmigen Abschnitts der obersten platzhaltenden Schicht 11 (siehe. Fig. 2) in die darüberliegende Oxidschicht 12 geformt. Das Ergebnis ist in Fig. 5 in einer Querschnittansicht entlang der Linie A-A der Fig. 2 gezeigt. Anschließend werden durch dieses Kontaktloch 8A sämtliche platzhaltenden Schichten bzw. Schichtzonen 3, 5A, 11 beispielsweise naßchemisch selektiv herausgeätzt. Als Ergebnis wird eine Struktur erhalten, in der freischwebende, als Kanalbereiche des herzustellenden Transistors vorgesehene Si-Stege (Halbleiter-Kanalzonen) 4A, 6A nur an ihren Stirnseiten durch die Source- und Drain-Bereiche 2A, 2B gehalten werden.

Anschließend werden die Isolationsschichten 9 beispielsweise durch thermisches Oxidieren geformt. Dabei bildet sich ein relativ dünnes Gateoxid 9 an den Si-Stege 4A, 6A und im Falle der Verwendung von dotiertem polykristallinen Silizium für die Source- und Drain-Bereiche 2A, 2B bildet sich aufgrund der Zunahme der Oxidwachstumsgeschwindigkeit mit dem Dotierungsgrad gleichzeitig ein dickeres thermisches Oxid 9 an den Source- und Drain-Bereichen 2A, 2B, wie in der Fig. 1 zu erkennen ist. Auch an der Oberseite der Source- und Drain-Bereiche 2A, 2B wird demzufolge ein relativ dickes thermisches Oxid gebildet.

Dann werden in den freigeätzten Bereichen, in denen sich vordem die platzhaltenden Schichten 3, 5A, 11 befunden hatten, die Gateelektroden 10A, 10B, 10C gebildet. Dies erfolgt vorzugsweise durch eine CVD-Abscheidung (chemische Dampfphasenabscheidung) von hochdotiertem Polysilizium. Die Dotierung erfolgt dabei in-situ, also während der Abscheidung, und das Dotiermaterial ist beispielsweise Phosphor, wodurch der Halbleiter n-leitend gemacht wird. Als Gateelektroden 10A, 10B, 10C kann jedoch auch ein Metall oder ein Metallsilizid abgeschieden werden. Anschließend erfolgt wieder ein Planarisieren der Oberfläche durch Rückätzen oder CMP.

Dadurch, daß die Ätzung der Vertiefungen 7A, 7B mit ein- und derselben Maske durchgeführt wird, wird somit gleichzeitig die Kanallänge und die Position der Gateelektroden definiert, wodurch erreicht wird, daß die Gateelektroden 10A, 10B, 10C sehr genau zueinander ausgerichtet sind.

In dem in Fig. 1 gezeigten Zustand der Transistoranordnung sind die Source- und Drain-Bereiche 2A, 2B noch nicht mit Metallkontakten versehen. Demnach werden schließlich noch in die deckenseitigen Oxidschichten 9 der Source- und Drain-Bereiche 2A, 2B Kontaktlöcher 8B, 8C geformt, deren Lagen durch die punktierten Linien in der Fig. 2 dargestellt sind. Diese Kontaktlöcher 8B, 8C werden metallisiert, wodurch Source- und Drain-Kontakte hergestellt sind.

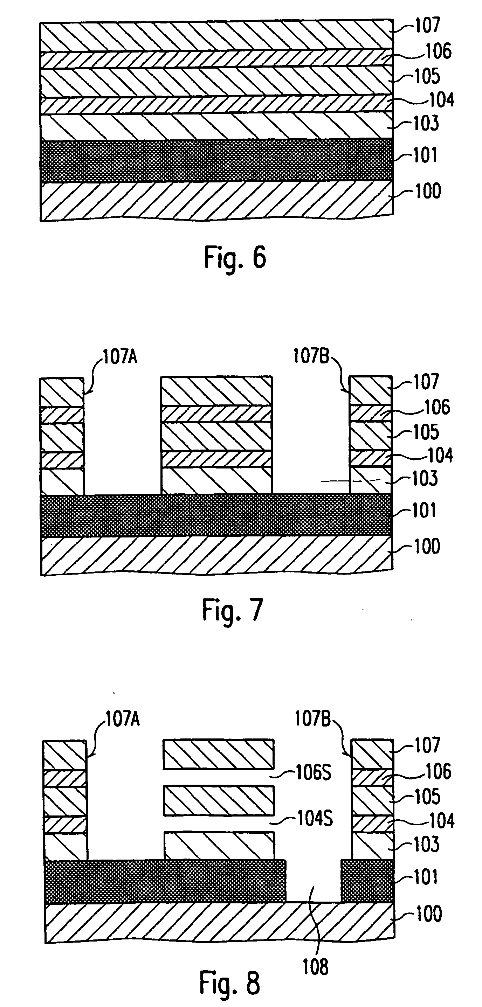

Die Fig. 6 bis 11 veranschaulichen eine weitere Variante zur erfindungsgemäßen Herstellung eines Mehrkanal-MOSFET. Auf einem Si-Substrat 100 wird eine Oxidschicht 101 aufgebracht. Gemäß Fig. 6 wird mittels CVD auf der Oxidschicht 101 eine Schichtfolge aufgebracht, die aus einer ersten platzhaltenden Schicht 103, einer beispielsweise aus SiO₂, amorphem oder polykristallinem Silizium bestehenden ersten Opferschicht 104, einer zweiten platzhaltenden Schicht 105, einer zweiten Opferschicht 106 aus den genannten Materialien und einer dritten platzhaltenden Schicht 107 aufgebaut ist. Wie noch deutlich wird, dienen die beiden Opferschichten 104, 106 dabei als abstandshaltende Schichten zur Erzeugung jeweils eines Spaltbereichs, welcher später zur Bildung der Halbleiter-Kanalschichtzonen genutzt wird. Dabei wird die Breite der Spaltbereiche (spätere Kanalbreite) in nicht dargestellter Weise bereits beim Aufbau der Schichtfolge durch geeignete, an den Opferschichten 104, 106 vorgenommene Maskier- und Ätzschritte festgelegt.

Die platzhaltenden Schichten 103, 105, 107 können aus einem der bei dem ersten Ausführungsbeispiel bereits genannten Materialien, insbesondere SiN bestehen.

Der nächste Maskier- und Ätzschritt definiert die Länge beider (bzw. aller) zu bildenden Halbleiter-Kanalschichtzonen und ist in der Fig. 7 gezeigt. Es werden zwei Vertiefungen 107A, 107B in die obere platzhaltende Schicht 107 sowie sämtliche darunterliegenden Schichten 106, 105, 104, 103 der Schichtfolge bis auf die Oxidschicht 101 (Stoppschicht) geätzt. An einander gegenüberliegenden Seitenwänden der Vertiefungen 107A, 107B liegen die Opferschichten 104, 106 der zwischen den Vertiefungen 107A, 107B stehenbleibenden Schichtstruktur stirnseitig frei.

Nun werden die Opferschichten 104, 106 beispielsweise durch eine KOH-Ätzung entfernt, wobei, wie in Fig. 8 gezeigt, zwei übereinander liegende und zueinander ausgerichtete hohle Spaltbereiche 104S, 106S oder Tunnel geschaffen werden. Die Tunnel 104S, 106S münden beidseitig in die Vertiefungen 107A, 107B und verbinden diese. Ihre lichte Höhe ist durch die Dicke der entfernten Opferschichten 104, 106 der Schichtstruktur bestimmt.

Die Tunnelwände können sodann in nicht dargestellter Weise durch eine konforme Niedertemperatur-Oxidierung (LTO: low temperature oxidation) mit einem Oxid überzogen werden.

Anschließend wird in einer der Vertiefungen, hier 107B, eine Öffnung 108 (seed window) in die bodenseitige Oxidschicht 101 eingebracht. Die sich ergebende Struktur ist in Fig. 8 dargestellt.

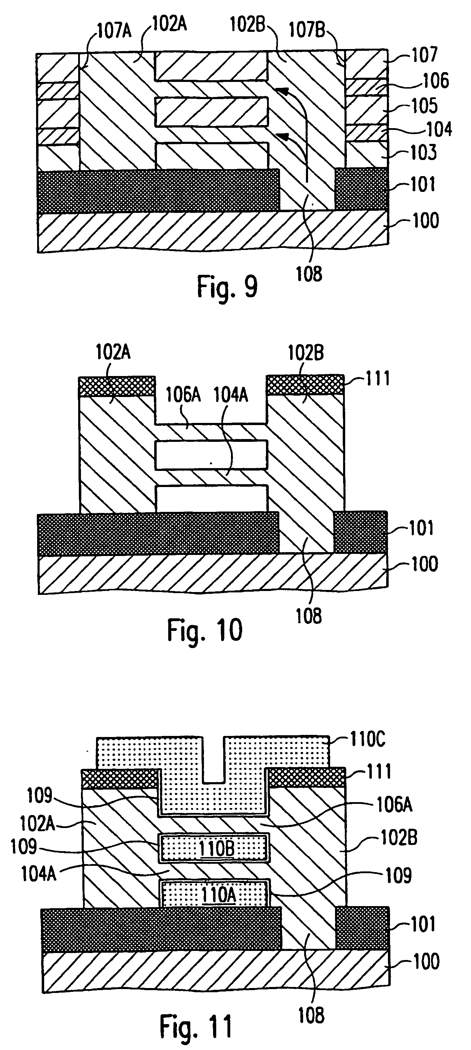

In einem folgenden Epitaxieschritt wird kristallines Silizium aus der Öffnung 108 in der Vertiefung 107B heraus durch die Tunnel hindurch in die Vertiefung 107A aufgewachsen. Das Wachstum findet dabei selektiv nur auf Silizium statt. Der Wachstumsprozeß wird fortgesetzt, bis die Vertiefungen 107A, 107B vollständig mit kristallinen Silizium gefüllt sind. Die aufgefüllten Vertiefungen 107A, 107B bilden die Source- 102A und Drain-Bereiche 102B der herzustellenden MOS-Transistoranordnung. Überschüssiges epitaktisches Silizium wird anschließend durch einen CMP-Prozeß entfernt, siehe Fig. 9.

Nach dem Epitaxieschritt werden die geschaffenen Source- 102A und Drain-Bereiche 102B geeignet dotiert.

Anschließend werden die freiliegenden Siliziumbereiche oxidiert (Oxidschicht 111) und die platzhaltenden Schichten 107, 105, 103 werden entfernt. Es bleiben dünne kristalline Stege 104A, 106A stehen, die die Source- und Drain-Bereiche 102A, 102B miteinander verbinden, siehe Fig. 10.

Durch einen weiteren Oxidationsschritt werden thermische Gateoxidschichten 109 einer gleichmäßigen Dicke auf die Stege 104A, 106A aufgebracht und auch an freien Wandabschnitten der Source- 102A und Drain-Bereiche 102B gebildet. In einem letzten Schritt werden die durch Entfernung der platzhaltenden Schichten 103, 105, 107 geschaffenen Freibereiche mittels eines CVD-Prozesses mit einem Gatematerial, beispielsweise Polysilizium gefüllt. Dabei entstehen wie in Fig. 11 dargestellt die Gateelektroden 110A, 110B, 110C.

Beiden Ausführungsvarianten ist gemeinsam, daß selbstjustierte Gateelektroden erzeugt werden, daß der geschaffene Mehrkanal-MOSFET einen geringen Platzbedarf beansprucht und der Herstellungsprozeß im Rahmen der CMOS-Technologie und unter Verwendung an sich bekannter Einzelprozesse skalierbar ist.

## Patentansprüche

1. Verfahren zur Herstellung einer MOS-Transistoranordnung mit den folgenden Verfahrensschritten
- Bereitstellen eines Substrats (1);
- optionales Aufbringen einer bodenseitigen platzhaltenden Schicht (3) auf das Substrat (1);
- Abscheiden einer Schichtfolge, die zumindest zwei Halbleiter-Kanalschichten (4, 6) mit einer dazwischenliegenden platzhaltenden Schicht (5) umfaßt, über dem Substrat (1);
- Entfernen der Schichtfolge (4, 5, 6) bis auf eine zurückbleibende Schichtstruktur (4A, 5A, 6A);
- zumindest dann, wenn keine bodenseitige platzhaltende Schicht (3) vorgesehen ist, Abscheiden einer weiteren platzhaltenden Schicht (11), die die Schichtstruktur (4A, 5A, 6A) überdeckt;
- Erzeugen von die Kanallänge der herzustellenden MOS-Transistoranordnung definierenden Seitenwänden der Schichtstruktur (4A, 5A, 6A) durch einen Maskier- und Ätzschritt, wobei sich die Seitenwände auch in die unter der Schichtstruktur (4A, 5A, 6A) liegende bodenseitige platzhaltende Schicht (3), sofern vorhanden, erstrecken;
- Anlagern von elektrisch leitfähigem Material an die beiden freigelegten Seitenwände zur Ausbildung von Source- (2A) und Drain-Bereichen (2B);
- selektives Entfernen sämtlicher platzhaltenden Schichten (3, 5A, 11);
- Erzeugen von Isolationsschichten (9) an durch Entfernung der platzhaltenden Schichten (3, 5A, 11) freigelegten Oberflächenbereichen; und
- Einbringen eines elektrisch leitfähigen Materials in die Bereiche der entfernten platzhaltenden Schichten (3, 5A, 11) zur Bildung von Gateelektroden (10A, 10B, 10C).

2. Verfahren nach Anspruch 1,
**dadurch gekennzeichnet, daß**
die platzhaltenden Schichten (3, 5, 11) und die Halbleiter-Kanalschichten durch eine Polysilizium-Abscheidung erzeugt werden, wobei die platzhaltenden Schichten durch Hinzufügung eines ein selektives Ätzverhalten gegenüber Polysilizium ermöglichenden Fremdstoffes, insbesondere P realisiert werden.

3. Verfahren nach Anspruch 1,
**dadurch gekennzeichnet, daß**
die Halbleiter-Kanalschichten (4, 6) durch eine Polysilizium-Abscheidung und die platzhaltenden Schichten (3, 5, 11) durch eine Poly-SiGe-Abscheidung erzeugt werden.

4. Verfahren nach Anspruch 1,
**dadurch gekennzeichnet, daß**
die platzhaltenden Schichten (3, 5, 11) und die Halbleiter-Kanalschichten (4, 6) durch eine epitaktische Silizium-Abscheidung erzeugt werden, wobei die platzhaltenden Schichten durch Hinzufügung eines ein selektives Ätzverhalten gegenüber kristallinem Silizium ermöglichenden Fremdstoffes realisiert werden.

5. Verfahren nach Anspruch 1,
**dadurch gekennzeichnet, daß**
die Halbleiter-Kanalschichten (4, 6) durch eine epitaktische Si-Abscheidung und die platzhaltenden Schichten (3, 5, 11) durch eine CaF₂- oder SiGe-Abscheidung erzeugt werden.

6. Verfahren nach Anspruch 1,
**dadurch gekennzeichnet, daß**
die platzhaltenden Schichten (3, 5, 11) durch Abscheidung von Siliziumnitrid gebildet werden.

7. Verfahren nach einem der Ansprüche 1 bis 6,
**dadurch gekennzeichnet, daß**
dotiertes polykristallines Silizium durch chemische Dampfphasenabscheidung zur Ausbildung der Source- (2A) und Drain-Bereiche (2B) an die Seitenwände angelagert wird und die Dotierung während der Abscheidung (in-situ), insbesondere durch Arsen-Atome, vorgenommen wird.

8. Verfahren nach einem der Ansprüche 1 bis 7,
**dadurch gekennzeichnet, daß**
in den Bereichen der entfernten platzhaltenden Schichten (3, 5A, 11) dotiertes polykristalline Silizium durch chemische Dampfphasenabscheidung zur Bildung der Gateelektroden (10A, 10B, 10C) verwendet wird und die Dotierung, insbesondere durch Phosphor-Atome, während der Abscheidung (in-situ) vorgenommen wird.

9. Verfahren nach einem der Ansprüche 1 bis 8,
**dadurch gekennzeichnet, daß**
zur Erzeugung der Seitenwände eine Isolationsschicht (12), insbesondere eine Oxidschicht über der Schichtstruktur (4A, 5A, 6A) und, sofern vorhanden, auf der weiteren platzhaltenden Schicht (11) abgeschieden wird.

10. Verfahren zur Herstellung einer MOS-Transistoranordnung mit den folgenden Verfahrensschritten
- Bereitstellen eines Substrats (100);
- Erzeugen einer Oxidschicht (101) auf dem Substrat (100);
- Abscheiden einer Schichtfolge, umfassend alternierend angeordnete platzhaltende Schichten (103, 105, 107) und Opferschichten (104, 106) über dem Substrat (100), wobei die Schichtfolge zumindest 2 Opferschichten (104, 106) enthält;
- Strukturieren der Schichtfolge unter Verwendung eines Maskier- und Ätzschrittes zur Erzeugung einer aus der Schichtfolge herausgeätzten Schichtstruktur, wobei sich senkrecht zur Kanalrichtung der herzustellenden MOS-Transistoranordnung erstreckende Seitenwände der Schichtstruktur durch eine einzige Maske definiert werden;
- Herausätzen der Opferschichten (104, 106) zwischen den strukturierten platzhaltenden Schichten (103, 105, 107) zur Erzeugung von Spaltbereichen (104S, 106S);
- benachbart einer Seitenwand Ätzen einer das Substrat freilegenden Öffnung (108) in die Oxidschicht (101);
- selektives epitaktisches Aufwachsen von Silizium aus der Öffnung (108) durch die Spaltbereiche (104S, 106S) hindurch, wobei in den Spaltbereichen (104S, 106S) übereinanderliegende Kanalschichtzonen und an den Enden der Spaltbereiche an die Seitenwände angrenzende Source- und Drain-Bereiche (102A, 102B) geschaffen werden;
- selektives Entfernen der strukturierten platzhaltenden Schichten (103, 105, 107);
- Erzeugen von Isolationsschichten an durch Entfernung der strukturierten platzhaltenden Schichten freigelegten Oberflächenbereichen; und
- Einbringen eines elektrisch leitfähigen Materials in den Bereichen der entfernten strukturierten platzhaltenden Schichten (103, 105, 107) zur Bildung von Gateelektroden (110A, 110B, 110C).

## Claims

1. Method for fabricating a MOS transistor arrangement, comprising the method steps of
- providing a substrate (1);
- optionally applying a base-side spacing layer (3) to the substrate (1);
- depositing a layer sequence, which comprises at least two semiconductor channel layers (4, 6) with a spacing layer (5) between them, over the substrate (1);
- removing the layer sequence (4, 5, 6) as far as a remaining layer structure (4A, 5A, 6A);
- at least if there is no base-side spacing layer (3), depositing a further spacing layer (11), which covers the layer structure (4A, 5A, 6A);
- producing side walls, which define the channel length of the MOS transistor arrangement to be fabricated, of the layer structure (4A, 5A, 6A) by a masking and etching step, with the side walls also extending into the base-side spacing layer (3), if present, below the layer structure (4A, 5A, 6A);
- accumulating electrically conductive material on the two uncovered side walls in order to form source (2A) and drain (2B) regions;
- selectively removing all the spacing layers (3, 5A, 11);
- producing insulation layers (9) at surface regions which have been uncovered through the removal of the spacing layers (3, 5A, 11); and
- introducing an electrically conductive material into the regions of the spacing layers (3, 5A, 11) which have been removed, in order to form gate electrodes (10A, 10B, 10C).

2. Method according to Claim 1, **characterized in that** the spacing layers (3, 5, 11) and the semiconductor channel layers are produced by a deposition of polysilicon, the spacing layers being realized by the addition of a foreign substance, in particular P, which allows selective etching with respect to polysilicon.

3. Method according to Claim 1, **characterized in that** the semiconductor channel layers (4, 6) are produced by deposition of polysilicon, and the spacing layers (3, 5, 11) are produced by deposition of poly-Si-Ge.

4. Method according to Claim 1, **characterized in that** the spacing layers (3, 5, 11) and the semiconductor channel layers (4, 6) are produced by epitaxial deposition of silicon, the spacing layers being realized by the addition of a foreign substance which allows selective etching with respect to crystalline silicon.

5. Method according to Claim 1, **characterized in that** the semiconductor channel layers (4, 6) are produced by epitaxial deposition of Si, and the spacing layers (3, 5, 11) are produced by deposition of CaF₂ or SiGe.

6. Method according to Claim 1, **characterized in that** the spacing layers (3, 5, 11) are formed by deposition of silicon nitride.

7. Method according to one of Claims 1 to 6, **characterized in that** doped polycrystalline silicon is accumulated on the side walls by chemical vapour deposition in order to form the source (2A) and drain (2B) regions, and the doping is carried out during the deposition (in situ), in particular using arsenic atoms.

8. Method according to one of Claims 1 to 7, **characterized in that** doped polycrystalline silicon is used to form the gate electrodes (10A, 10B, 10C) by chemical vapour deposition in the regions of the removed spacing layers (3, 5A, 11), and the doping, in particular by phosphorus atoms, is carried out during the deposition (in situ).

9. Method according to one of Claims 1 to 8, **characterized in that** to produce the side walls an insulation layer (12), in particular an oxide layer, is deposited over the layer structure (4A, 5A, 6A) and, if present, on the further spacing layer (11).

10. Method for fabricating a MOS transistor arrangement, comprising the method steps of
- providing a substrate (100);
- producing an oxide layer (101) on the substrate (100);
- depositing a layer sequence, comprising alternately arranged spacing layers (103, 105, 107) and sacrificial layers (104, 106) over the substrate (100), the layer sequence including at least two sacrificial layers (104, 106);
- patterning the layer sequence using a masking and etching step to produce a layer structure etched out of the layer sequence, with side walls of the layer structure, which extend perpendicular to the channel direction of the MOS transistor arrangement to be fabricated, being defined by a single mask;
- etching out the sacrificial layers (104, 106) between the patterned spacing layers (103, 105, 107) to produce gap regions (104S, 106S);
- adjacent to a side wall, etching an opening (108), which uncovers the substrate, into the oxide layer (101);
- selectively epitaxially growing silicon from the opening (108) through the gap regions (104S, 106S), so that channel layer zones located one above another are created in the gap regions (104S, 106S), and source and drain regions (102A, 102B), which adjoin the side walls, are created at the ends of the gap regions;
- selectively removing the patterned spacing layers (103, 105, 107);
- producing insulation layers at surface regions which have been uncovered by removal of the patterned spacing layers; and
- introducing an electrically conductive material in the regions of the patterned spacing layers (103, 105, 107) which have been removed, so as to form gate electrodes (110A, 110B, 110C).

## Revendications

1. Procédé de fabrication d'un dispositif à transistor MOS avec les étapes suivantes :
- préparation d'un substrat (1) ;
- application optionnelle d'une couche de réserve (3) du côté du fond sur le substrat (1) ;
- dépôt d'une succession de couches, qui comprend au moins deux couches de canal semi-conductrices (4, 6) avec une couche intercalaire de réserve (5), au-dessus du substrat (1) ;
- élimination de la succession de couches (4, 5, 6) sauf une structure en couches restante (4A, 5A, 6A) ;
- au moins lorsqu'il n'est pas prévu de couche de réserve (3) du côté du fond, dépôt d'une autre couche de réserve (11), qui recouvre la structure en couches (4A, 5A, 6A) ;
- production de parois latérales, définissant la longueur de canal du dispositif à transistor MOS à fabriquer, de la structure en couches (4A, 5A, 6A) par une étape de masquage et de gravure, les parois latérales s'étendant aussi dans la couche de réserve (3) du côté du fond et située sous la structure en couches (4A, 5A, 6A) dans la mesure où elle existe ;
- fixation de matériau électriquement conducteur sur les deux parois latérales dégagées pour former des zones de source (2A) et de drain (2B) ;
- élimination sélective de toutes les couches de réserve (3, 5A, 11) ;
- production de couches d'isolation (9) sur les zones de surface dégagées par l'élimination des couches de réserve (3, 5A, 11) ; et
- introduction d'un matériau électriquement conducteur dans les zones des couches de réserve (3, 5A, 11) pour former des électrodes de grille (10A, 10B, 10C).

2. Procédé selon la revendication 1,
**caractérisé par le fait que** les couches de réserve (3, 5, 11) et les couches de canal semi-conductrices sont produites par un dépôt de polysilicium, les couches de réserve étant réalisées par l'ajout d'une matière étrangère, notamment P, permettant une gravure sélective par rapport au polysilicium.

3. Procédé selon la revendication 1,
**caractérisé par le fait que** les couches de canal semi-conductrices (4, 6) sont produites par un dépôt de polysilicium et les couches de réserve (3, 5, 11) sont produites par un dépôt de poly-SiGe.

4. Procédé selon la revendication 1,
**caractérisé par le fait que** les couches de réserve (3, 5, 11) et les couches de canal semi-conductrices (4, 6) sont produites par un dépôt épitaxial de silicium, les couches de réserve étant réalisées par l'ajout d'une matière étrangère permettant une gravure sélective par rapport au silicium cristallin.

5. Procédé selon la revendication 1,
**caractérisé par le fait que** les couches de canal semi-conductrices (4, 6) sont produites par un dépôt épitaxial de Si et les couches de réserve (3, 5, 11) sont produites par un dépôt de CaF₂ ou SiGe.

6. Procédé selon la revendication 1,
**caractérisé par le fait que** les couches de réserve (3, 5, 11) sont formées par dépôt de nitrure de silicium.

7. Procédé selon l'une des revendications 1 à 6,
**caractérisé par le fait que** du silicium polycristallin dopé est fixé sur les parois latérales par un dépôt chimique en phase vapeur pour former les zones de source (2A) et de drain (2B) et que le dopage est effectué pendant le dépôt (in situ), notamment avec des atomes d'arsenic.

8. Procédé selon l'une des revendications 1 à 7,
**caractérisé par le fait que**, dans les zones des couches de réserve (3, 5A, 11) éliminées, du silicium polycristallin dopé est utilisé par un dépôt chimique en phase vapeur pour former les électrodes de grille (10A, 10B, 10C) et le dopage, notamment avec des atomes de phosphore, est effectué pendant le dépôt (in situ).

9. Procédé selon l'une des revendications 1 à 8,
**caractérisé par le fait que**, pour produire les parois latérales, une couche d'isolation (12), notamment une couche d'oxyde, est déposée au-dessus de la structure en couches (4A, 5A, 6A) et, dans la mesure où elle existe, sur l'autre couche de réserve (11).

10. Procédé de fabrication d'un dispositif à transistor MOS avec les étapes suivantes :
- préparation d'un substrat (100) ;
- production d'une couche d'oxyde (101) sur le substrat (100) ;
- dépôt d'une succession de couches, qui comprend des couches de réserve (103, 105, 107) et des couches sacrifiées (104, 106) disposées en alternance au-dessus du substrat (100), la succession de couches contenant au moins 2 couches sacrifiées (104, 106) ;
- structuration de la succession de couches en utilisant une étape de masquage et de gravure pour la production d'une structure en couches gravées à partir de la succession de couches, des parois latérales de la structure en couches qui s'étendent perpendiculairement à la direction de canal du dispositif à transistor MOS à fabriquer étant définies par un seul masque ;
- gravure des couches sacrifiées (104, 106) entre les couches de réserve structurées (103, 105, 107) pour la production de zones vides (104S, 106S) ;
- au voisinage d'une paroi latérale, gravure d'une ouverture (108) dégageant le substrat dans la couche d'oxyde (101) ;
- croissance épitaxiale sélective de silicium à partir de l'ouverture (108) à travers les zones vides (104S, 106S), des zones de couche de canal superposées étant créées dans les zones vides (104S, 106S) et des zones de source et de drain (102A, 102B) adjacentes aux parois latérales étant créées aux extrémités des zones vides ;
- élimination sélective des couches de réserve structurées (103, 105, 107) ;
- production de couches d'isolation sur des zones de surface dégagées par l'élimination des couches de réserve structurées ; et
- application d'un matériau électriquement conducteur dans les zones des couches de réserve structurées (103, 105, 107) éliminées pour former les électrodes de grille (110A, 110B, 110C).
